# EUROPEAN PATENT APPLICATION

(11) **EP 1 480 224 A1**
(43) Date of publication of application: **24.11.2004**
(21) Application number: 03425332.8
(22) Date of filing: 22.05.2003
(51) Int. Cl.: G11C 5/06, G06F 13/40

(54) **A semiconductor memory with a multiprotocol serial communication interface**

(71) Applicant: STMicroelectronics S.r.l., 20041 Agrate Brianza (Milano) (IT)
(72) Inventor: Perroni, Maurizio Francesco, 98054 Furnari (IT); Scavuzzo, Andrea, 90143 Palermo (IT); Polizzi, Salvatore, 90141 Palermo (IT); Polizzi Salvatore, 90141 Palermo (IT)
(74) Representative: Maccalli, Marco

(57) **Abstract**

An integrated circuit includes a standard memory, having an addressing parallelism and a data transfer parallelism, and a multiprotocol serial communication interface, configurable for interfacing the memory with a selected one among at least a first and a second external serial buses, having respectively a first and a second parallelism of transfer of address codes for the memory and data words, the second parallelism being smaller than the first parallelism and the first parallelism being smaller than the addressing parallelism and the data transfer parallelism of the memory. The multiprotocol serial communication interface includes a storage register of address codes, a storage register of data words read from the memory, means for the selective coupling of the address code storage register and of the data word storage register to a first or to a second group of electric terminals of the integrated circuit, for the connection of the integrated circuit to the first or to the second bus. The communication interface additionally includes control means to enable: the loading into the address code storage register of address codes received serially through the first or the second bus; the supply of the loaded address codes in parallel to the memory; the loading into the data word storage register of data words received in parallel from the memory, and the transfer of the loaded data words serially onto the first or the second bus.

## Description

The present invention generally relates to the field of integrated circuits, and more particularly to the field of memory integrated circuits.

In several applications it is important to use electronic components that are capable of interacting with the surrounding electronic system, wherein they are put, through as few as possible signals. In such way, it is possible to limit the number of electrical terminals (pins) of the the integrated circuit packages, thus reducing the cost and the dimensions thereof. Moreover, integrated circuits inserted in smaller packages and having a small number of electrical terminals allow reducing the area to be reserved thereto on the printed circuit boards intended to house them, and also allow reducing the number of signal lines to be distributed on the boards. All this translates into a significant cost reduction.

Particularly, in the field of digital electronic systems, communication protocols and related communication bus architectures have been therefore proposed, which are adapted to limit the number of signals necessary to the exchange of data between the different components of the system.

An example of such protocols is the protocol called Low Pin Count (shortly, LPC). Such protocol provides for a communication bus made up of a reduced number of signal lines: four signal lines for transferring address codes (defining for example addresses of memory locations that have to be accessed, for instance by a microprocessor, for reading or for modifying the content thereof), data words (for instance, data read from, or to be written into, one or more memory locations) and command codes, through a time division multiplexing scheme; a signal line for transferring a clock signal; a signal line for transferring a signal indicative of the start of a communication transaction between two components connected to the bus. Other signal lines can be and are often provided, but they have an optional character.

Another of such protocols is the protocol called Serial Peripheral Interface (shortly, SPI), that allows having a communication bus with a number of signal lines even smaller than that of the LPC protocol.

As far as memory integrated circuits are concerned, it is known that they require, among others, a plurality of signal lines for receiving related address codes, and a plurality of data output signal lines (in the case of read-only memories) or of data input/output signal lines (in the case of read and write memories). Particularly, the number of addres signal lines necessary to the memory substantially depends on the size of the memory device, *i.e.* on the number of memory locations, while the number of data output or input/output signal lines depends on the width (in terms of number of bits) of each memory location. For instance, considering the field of non-volatile memories, Flash memories with a number of memory locations of the order of some millions, of eight or sixteen bits each, are now rather common.

This high parallelism in terms of both addressing and data transfer is fundamental in applications that require high access and data transfer speeds from/to the memory, but it imposes the use of costly packages having a high number of pins: a typical package for a Flash memory of average dimensions must in fact have a number of pins of the order of some tens.

Nevertheless, also when the applications would allow it, *i.e.* when the requirements in terms of access and data transfer speed are not particularly strict, the standard design of memory integrated circuits does not allow using packages having a low number of pins. In other terms, it is not possible to exploit the same memory integrated circuit for applications of low performances and cost, simply placing the integrated circuit in a package with a reduced number of pins.

On the other hand, designing a totally new memory integrated circuit with the only purpose of limiting the number of pins of the package intended to house it is not a particularly desirable solution, since, where possible, it is always preferable to re-use already existing, tested and reliable designs.

Recently, the Applicant has proposed a component that integrates, in a same semiconductor chip, a standard non-volatile memory of the Flash or EPROM type, designed in such a way to have a high parallelism of addressing and data transfer, and a communication interface with a communication bus of reduced number of signal lines similar to the standard LPC. Thanks to the presence of such interface, the standard Flash memory or EPROM can be connected to and accessed through a bus of reduced number of signal lines. The number of electric terminals of the integrated circuit is quite lower than the number that would be necessary for directly interfacing the Flash memory: the integrated circuit can thus be put into a package having a reduced number of pins (for instance, sixteen), with consequent significant reduction of costs.

In view of the state of the art outlined above, it has been an object of the present invention to provide a component that, although including a memory of standard design, particularly but not limitatively a non-volatile memory such as an EPROM or a Flash, which is characterised by high parallelism of addressing and data transfer from/to the memory, could nevertheless be interfaced with at least two different types of buses having a reduced number of signal lines, particularly a bus according to the standard LPC and a bus according to the standard SPI that, as mentioned, requires a still smaller number of signal lines, and could therefore be put in very cheap packages.

According to the present invention, this and other objects have been attained by means of an integrated circuit comprising a standard memory, having an addressing parallelism and a data transfer parallelism, and a multiprotocol serial communication interface configurable for interfacing the memory with a selected one among at least a first and a second external serial communication buses, said first and second external communication bus having respectively a first and a second transfer parallelism of address codes for the memory and of data words, the second parallelism being smaller than the first parallelism and the first parallelism being in turn smaller than the addressing parallelism and the data transfer parallelism of the memory.

The multiprotocol serial communication interface includes an address code storage register, at least one data storage register for storing data words read from the memory, means for the selective coupling of the address code storage register and the data word storage register to a first or a second group of electric terminals of the integrated circuit, for the connection of the integrated circuit to the first or to the second bus, respectively.

The multiprotocol serial communication interface additionally includes control means for enabling the loading of the address code storage register with address codes received serially through the first or the second buses, and for feeding the loaded address codes in parallel to the memory; the control means also enable the loading of the data word storage register with data words received in parallel from the memory and the serial transfer of the loaded data words onto the first or on the second buses.

In the case the memory is also electrically programmable, the control means are also adapted to enable the loading of a write data word storage register (different from or coincident with the read data word storage register) with data words to be written into the memory, received in series from the first or from the second buses, and the transfer in parallel to the memory of the data words to be written thereinto.

The features and advantages of the present invention will be made apparent by the following detailed description of an embodiment thereof, provided merely by way of a non-limitative example, that will be done making reference to the attached drawings, wherein:
FIG. 1 shows the main functional blocks of an integrated circuit according to an embodiment of the present invention, comprising a semiconductor memory, connected to a first type of external communication bus, particularly a bus according to the LPC communication protocol;
FIG. 2 shows the integrated circuit of FIG. 1 connected to a second type of external communication bus, particularly a bus according to the SPI communication protocol;
FIG. 3 schematically shows the structure of an address register and of a demultiplexing block of a communication interface of the integrated circuit of FIG. 1;
FIG. 4 schematically shows the structure of a data register and of a multiplexing/demultiplexing block of the communication interface;
FIG. 5 is a simplified diagram of the timing of a read access operation to the memory, accomplished according to the LPC protocol; and
FIG. 6 is a simplified diagram of the timing of an read access operation to the memory accomplished according to the SPI protocol.

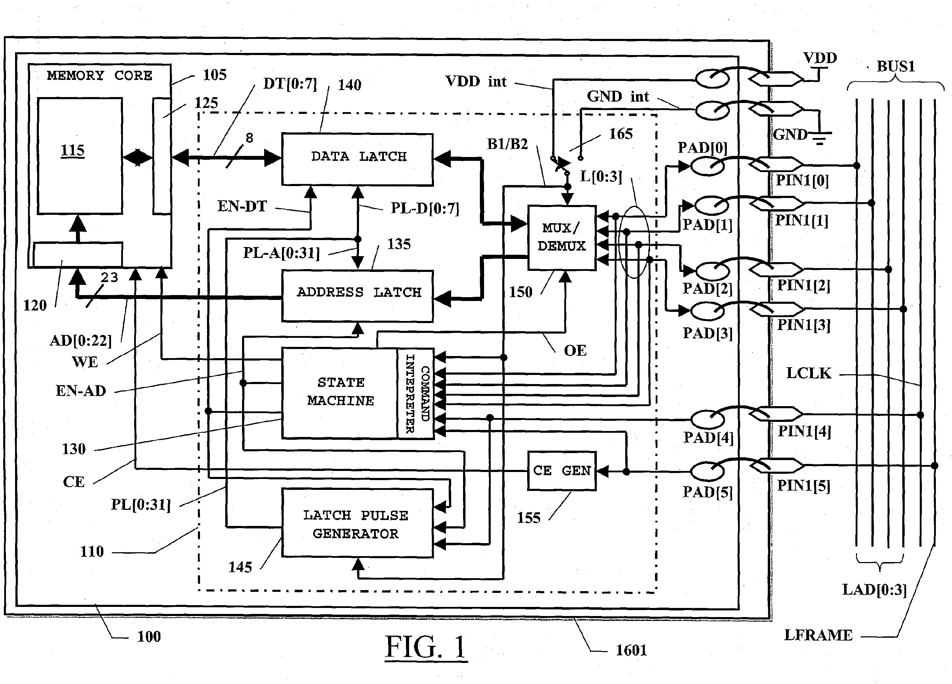

With reference to the annexed drawings, in FIG. 1 there are shown the main functional blocks of an integrated circuit according to an exemplary embodiment of the present invention. The integrated circuit includes, integrated in a same semiconductor material chip schematically represented as a block 100, a semiconductor memory 105 and a communication interface 110 adapted to interface, *i.e.* to allow the communication between, the memory 105 and external devices (not shown), through suitable communication buses. Such external devices can for instance include a microprocessor, a microcontroller, a memory controller, a digital signal processor (DSP) and the like.

The memory 105 is for example a standard non-volatile memory, particularly but not limitatively an electrically programmable and erasable memory such as a Flash memory. The memory 105 includes a matrix 115 of memory cells, for instance MOS transistors with a floating gate, arranged to form a plurality of memory locations. The memory locations are selectively accessed, in reading or in writing, by supplying to the memory 105 an address code, composed of a prescribed number of bits, that depends on the memory capacity; through known decoder and selection circuits, schematized in the drawing by a block identified by 120, the address code supplied to the memory is decoded and a corresponding location of the memory is univocally selected. Known read/write circuits, schematized in the drawing by a block identified by 125, allow reading/writing data from/into the selected memory location. The data read from or to be written into the selected memory location are put on data input/output terminals of the memory 105. Merely by way of example, in the following it will be supposed that the memory 105 is adapted to receive an address code of twenty-three bits, and that the memory has a data input/output parallelism of eight bits (one byte); in a standard memory, the data input/output parallelism normally coincides with the dimension (in terms of number of bits) of the respective memory locations, for which, in the considered example, so that the memory 105 has a capacity of eight megabytes.

The address code is supplied to the memory 105 through an address bus AD[0:22] composed of twenty-three signal lines, while the eight data input/output terminals of the memory are connected to a data bus DT[0:7] constituted by eight signal lines. The signal lines of the address bus and of the data bus are for instance lines defined in one or more metal layers of the integrated circuit.

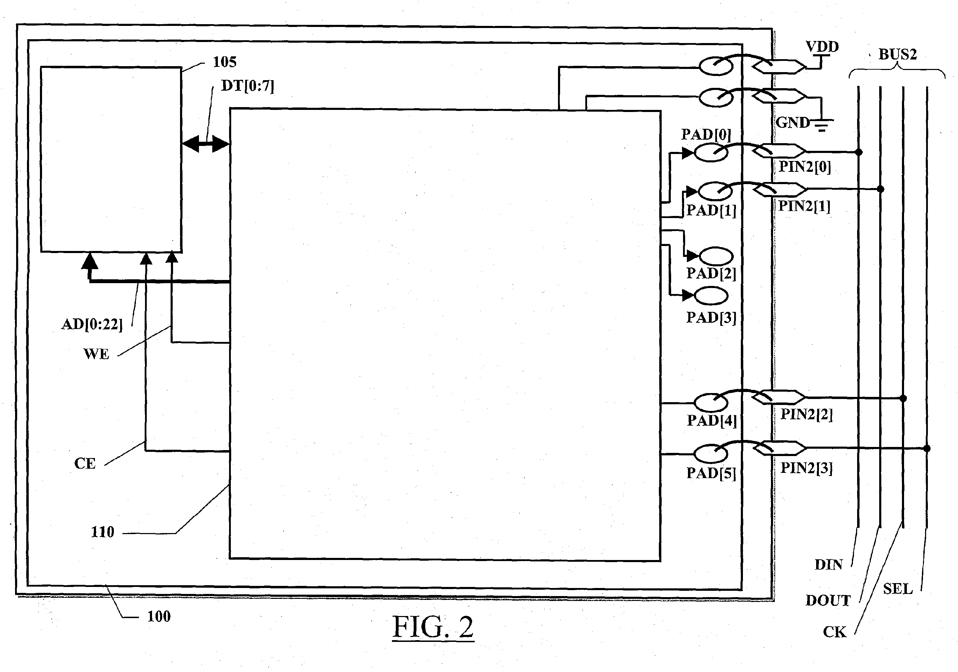

As already mentioned, the integrated communication interface 110 allows putting the memory 105 in communication with external devices through a prescribed communication bus. In the exemplary embodiment of the invention herein described, the communication interface 110 is adapted to interface the memory 105 to a selected one among a first type of communication bus BUS1 (schematically shown in FIG. 1) and a second type of communication bus BUS2 (schematically shown in FIG. 2).

Particularly, in the exemplary and non-limitative embodiment of the invention herein described and schematically shown in FIG. 1, the first type of bus BUS1 is a bus conforming to the Low Pin Count (shortly, LPC) standard; the bus BUS1 includes in particular: four signal lines LAD[0:3], used in a time-division multiplexed scheme for transferring in a serial way, by blocks of four bits at a time (a so-called "nibble"), address codes and data words to/from the memory; a signal line LCLK used for transferring a clock signal adapted to syncronize the operations of the different devices connected to the bus BUS1; and a signal line LFRAME used for transferring a signal indicative of the start of a communication transaction between two devices connected to the bus BUS1. Other signal lines of the bus BUS1, contemplated by the standard LPC, can be provided for, but, not being relevant for the purposes of the present description, they are not shown in the drawing.

Still in the exemplary embodiment of the invention herein described and schematically shown in FIG. 2, the second type of bus BUS2 is a serial bus conforming to the Serial Peripheral Interface (SPI) standard. The bus BUS2 includes, in addition to possible further signal lines contemplated by the standard SPI, but not described herein because not relevant for the purposes of the present invention: a signal line DIN used for transferring to the memory 105, in serial way and one bit at a time, address codes and data words to be written into the memory 105; a signal line DOUT used for transferring, in serial way and one bit at a time, the data words read from the memory 105; a clock signal line CK, for synchronizing the operations of the different devices connected to the bus BUS2; and a selection signal line SEL, for the selection of the component with which the device that has been assigned the control the bus BUS2 desires to communicate.

The integrated communication interface 110 includes: a control unit 130 of the communication interface 110 and of the memory 105; an address storage register 135 (in the following, for brevity, address register); a data storage register 140 (in the following, for brevity, data register); a sequencer circuit 145 for generating timing signals for properly clocking the address register 135 and the data register 140; a multiplexing/demultiplexing circuit 150; and a control circuit 155 for controlling the turning on of the memory 105.

The address register 135 is adapted to store an address code for the memory 105. The address code for the memory 105, in the example described herein comprising twenty-three bits, is received by the integrated circuit in a serial way, through one of the two buses BUS1, BUS2; the serially-received address code is progressively stored in the register 135 and, when completely received, it is supplied to the memory 105 in parallel, the whole twenty-three bits at a time, through the address bus AD[0:22]. Particularly, the address code is received by groups of four bits if the integrated circuit 100 is connected to the bus BUS1, or by single bits, if the integrated circuit is connected to the bus BUS2.

Similarly to the address register 135, the data register 140 is adapted to store a data word of dimensions corresponding to the data input/output parallelism of the memory 105, *i.e.* to the dimension of the data word of the memory 105, in the example herein considered eight bits.

In the case in which, through the interface 110, the memory 105 is accessed in reading, the data word read by the memory 105 and provided on the data input/output terminals thereof is sent in parallel, through the data bus DT[0:7], to the data register 140, wherein it is temporarily stored; the data word stored in the data register 140 is then transferred in a serial way to the correct signal lines of the bus BUS1 or of the bus BUS2 external to the integrated circuit. Particularly, in the case in which the integrated circuit 100 is connected to the external bus BUS1, the data word stored in the data register 140 is transferred to the four signal lines LAD[0:3] of the external bus BUS1 by groups of four bits at a time; in the case in which the integrated circuit 100 is instead connected to the external bus BUS2, the data word stored in the data register 140 is transferred to the signal line DOUT of the bus BUS2 only one bit at a time.

In the case in which, through the interface 110, the memory 105 is accessed in writing, the data word to be written into the memory is received in serial way from the external communication bus BUS1, and it is progressively stored in the data register 140; the data word stored in the data register 140 is then supplied in parallel to the data input/output terminals of the memory 105 through the data bus D[0:7]. Particularly, in the case in which the integrated circuit is connected to the external bus BUS1, the data word to be written is received over the four signal lines LAD[0:3] of the external bus BUS1 by groups of four bits at a time; in the case in which the integrated circuit is connected instead to the external bus BUS2, the data word to be written is received over the signal line DIN of the bus BUS2 only one bit at a time.

The multiplexing circuit 150 allows selectively connecting the address register 135 and the data register 140 to four signal lines of the integrated circuit, identified altogether by L[0:3], each one terminating in a respective contact pad PAD [0] -PAD [3] of the integrated circuit 100. In the case in which the integrated circuit 100 is intended for applications in which it has to be interfaced to the bus BUS1, each one of the four contact pads PAD[0:3] is destined to be connected, through a respective electric terminal or pin PIN1 [0] - PIN1 [3] of a first type of package 1601 for the integrated circuit 100, to a respective line of the four signal lines LAD[0:3] of the bus BUS1. In the case instead the integrated circuit 100 is intended for applications in which it has to be interfaced to the bus BUS2 (as shown in FIG. 2), the contact pads PAD [0] and PAD[1] are destined to be connected, through a respective pin PIN2 [0] and PIN2 [1] of a second type of package 1602 for the integrated circuit 100, to the signal lines DIN and DOUT of the bus BUS2, respectively; the remaining two contact pads PAD [2] and PAD [3] are instead destined to be left disconnected (the package 1602, unlike the package 1601, can then lack of the pins corresponding to the pins PIN1 [2] and PIN1 [3]).

The operation of the multiplexing circuit 150, that will be described in greater detail in the following, is determined for instance by a bus selection signal B1/B2, particularly a logic signal, through which the type of communication bus is selected with which the memory device is intended to be interfaced; a first logic state of the signal B1/B2, for instance the high logical state, sets the circuit 150 in a condition adapted to interfacing the bus BUS1, while the opposite logic state sets the multiplexing circuit 150 in a condition adapted to interfacing the bus BUS2. The logic state of the bus selection signal B1/B2 is for instance determined by logic state switching means 165, integrated in the integrated circuit 100, for example set directly in the manufacturing or testing phase of the integrated circuit 100; the logic state switching means are adapted to connect the line carrying the bus selection signal B1/B2 to a supply voltage distribution line VDD_int for distributing a supply voltage VDD or, alternatively, to a reference voltage distribution line GND int for distributing a reference voltage (ground) GND_int of the integrated circuit, said distribution lines VDD_int and GND_int being destined to be respectively connected to a supply voltage VDD and to a reference voltage GND external to the integrated circuit through respective dedicated contact pads and pins of the package 1601 or 1602. In the practice, the logic state switching means 165 can be constituted by a pair of metal lines, one of which can be interrupted by burning during the testing of the integrated circuit, or by a non-volatile memory element (of the UPROM type, used for implementing the redundance in the memory devices); in further alternative, the line carrying the logic signal B1/B2 can be connected to one or to the other of the supply voltage or reference voltage distribution lines using, for the manufacturing of the integrated circuit, a selected one between two alternative photolithographic masks for the definition of the metal lines of the integrated circuit.

The operation of the multiplexing/demultiplexing circuit 150 is also controlled by a signal OE for enabling the integrated circuit to output data; the signal OE is generated by the control unit 130 and, in the case in which the memory 105 is accessed in reading, enables the transfer of the data read from the memory 105 and stored in the data register 140 onto the correct signal lines of the external bus to which the integrated circuit is connected.

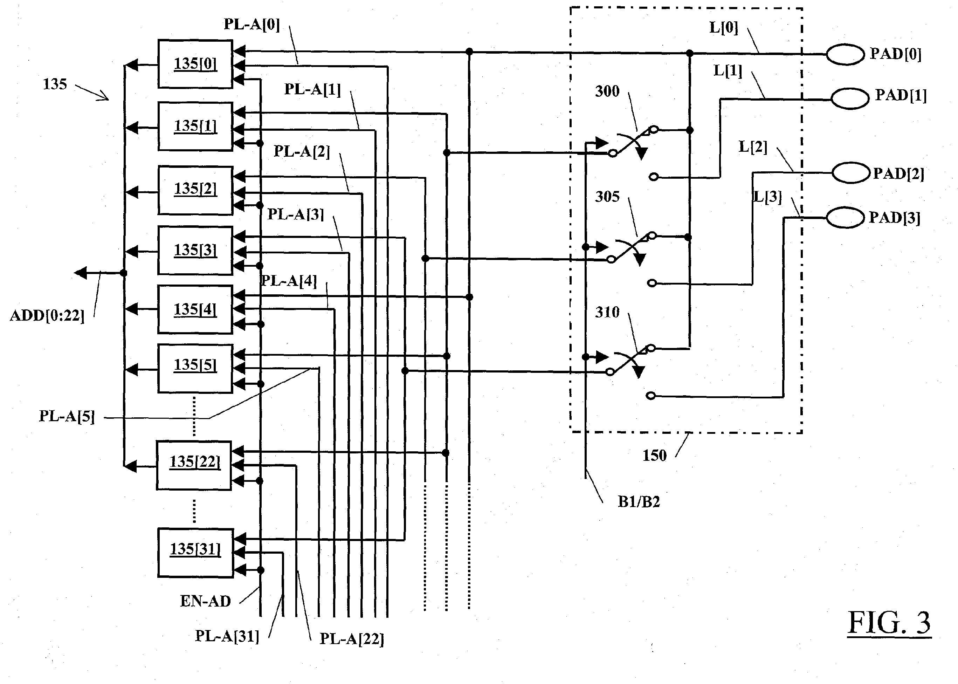

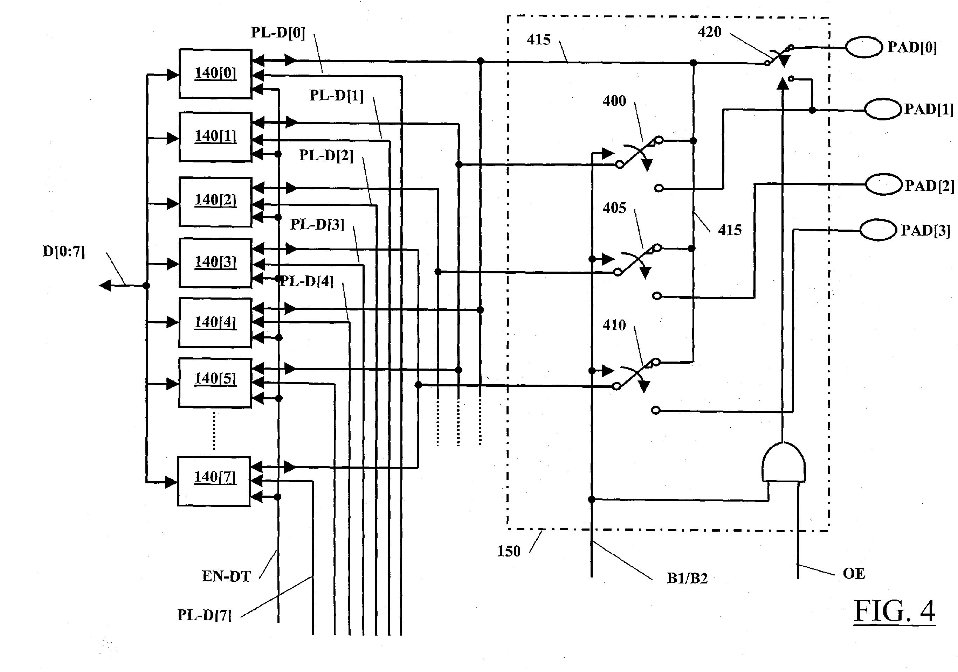

FIGG. 3 and 4 show still schematically but in greater detail the structure of the address register 135, of the data register 140 and of the multiplexing/demultiplexing circuit 150, in an embodiment of the present invention.

With reference to FIG. 3, the address register 135 comprises a number of unitary bistable elements (latches) at least equal to the overall number of bits of the address code of the memory 105: in the exemplary embodiment of the invention herein described, the address register 135 comprises therefore at least twenty-three latches 135[0:22], used for storing each one a respective bit of an address code to be supplied to the memory 105. The address register 135 can include a greater number of latches, so that the same communication interface 110 can be used, without the need of being re-designed, in association with memories 105 of greater dimensions, working on the basis of address codes containing a greater number of bits: particularly, in the example shown in FIG. 3, the address register 135 comprises thirty-two latches 135[0:31], but only twenty-three of these latches are actually used for storing address codes for accessing the memory 105. Each one of the latches 135 [0:31] has a data input, a data output, an input for a signal EN-AD enabling the loading of the data, global for all the latches of the address register 135 and generated by the control unit 130, and an input for a respective clock signal PL-A [0] - PL-A[31], generated by the sequencer circuit 145, causing (when the enable signal EN-AD is asserted) the loading into the associated latch of the datum present at the respective data input (for instance, at the rising edge of the respective clock signal). The data outputs of the twenty-three latches 135[0:22] are connected to the address bus AD[0:22], each data output being in particular connected to a respective line of the bus AD[0:22], while the data outputs of the remaining latches are left unconnected.

Through the multiplexing circuit 150, the data inputs of each latch 135 [0: 31] that composes the address register 135 is selectively connectable to one of the signal lines L[0:3], and therefore to one of the contact pads PAD[0:3] of the integrated circuit 100. Particularly, the latches 135[0:31] of the address register 135 are ideally grouped in groups of four latches; the first latch of each group, for instance the latch 135 [0] , the latch 135 [4] etc., has the respective data input connected, through the signal line L [0] , to the contact pad PAD [0] . The second latch of each group, for instance the latch 135[1], the latch 135[5] etc., has the data input alternatively connectable, through a switch 300, to the signal line L[0] or to the signal line L[1], thus to the pad PAD [0] or to the pad PAD[1]. The third latch of each group, for instance the latch 135[2] etc., has the data input alternatively connectable, through a switch 305, to the signal line L [0] or to the signal line L[2], and thus to the pad PAD [0] or to the pad PAD [2]. The fourth latch of each group, for instance the latch 135[3], has the data input alternatively connectable, through a switch 310, to the signal line L [0] , and thus to the pad PAD [0], or to the signal line L[3], thus to the pad PAD [3]. The switches 300, 305 and 310 are for instance controlled by the bus selection signal B1/B2, that selects the type of bus to which the integrated circuit is destined to interface.

Making reference to FIG. 4, the data register 140 comprises a number of latches equal to the number of data input/output terminals of the memory 105, *i.e.* to the data input/output parallelism of the memory 105, corresponding to the number of bits in the data word of the memory, in the example herein described eight latches 140[0:7]. Each latch has a first data input/output port, a second data input/output port, an input for a signal EN-DT enabling the loading of the data into the latch, global for all the latches of the data register and generated by the control unit 130, and an input for a respective clock signal PL-D [0] -PL-D [7] , generated by the sequencer circuit 145. The first data input/output port of each latch 140 [0:7] is connected to a respective line of the data bus DT [0 : 7], and therefore to a respective data input/output terminal of the memory 105. The second data input/output port of each latch 140[0:7] is selectively couplable to one of the contact pads PAD[0:3] through the multiplexing circuit 150. Particularly, similarly to the address register, the latches 140 [0:7] of the data register 140 are ideally grouped in groups of four latches; the first latch of each group, for instance the latch 140 [0] and the latch 140 [4] , has the second data input/output port connected to an internal data input/output line 415 alternatively connectable, through a switch 420 driven by a signal resulting from a logical combination of the bus selection signal B1/B2 and of the signal OE (asserted by the control unit 130 in the phase of outputting of the data word stored in the data register 140), to the contact pad PAD [0] or to the contact pad PAD [1]. The second latch of each group, for instance the latch 140[1] and the latch 140[5], has the second data input/output port alternatively connectable, through a switch 400, to the internal line 415 or to the pad PAD [1] . The third latch of each group, for instance the latch 140[2], has the second data input/output port alternatively connectable, through a switch 405, to the internal line 415 or to the pad PAD [2] . The fourth latch of each group, for instance the latch 140[3], has the second data input/output port alternatively connectable, through a switch 410, to the internal line 415 or to the pad PAD[3]. The switches 400, 405 and 410 are controlled by the bus selection signal B1/B2, that selects the type of bus to which the integrated circuit 100 is intended to be interfaced, while the switch 420 is controlled by a logic combination (particularly, a logic AND) of the signal B1/B2 and of the signal OE, that is asserted by the control unit 130 to enable the transfer onto the external bus BUS1 or BUS2 of the data read from the memory 105.

Similarly to the address register 135, also the data register 140 may include a number of latches higher than the data input/output parallelism of the memory 105, to render the communication interface re-usable with different memories without the need of re-design.

It is observed that, from a practical point of view, the latches of the address register 135 and of the data register 140 can comprise common flip-flops.

The control unit 130 includes a command interpreter and a sequential logic adapted to implement a state machine. The command interpreter interprets commands received by the integrated circuit 100 through the lines LAD[0:3] of the bus BUS1 or the line DIN of the bus BUS2. To such end, the command interpreter of the control unit 130 is connected to the signal lines L[0:3]. The bus selection signal B1/B2 allows the control unit to know to which bus the integrated circuit is destined to be interfaced. Depending on the received command, for instance a read command of the memory 105 or a write command into the memory 105, the state machine of the control unit 130 determines the proper sequence of operations for the execution of such command. Particularly, the state machine controls the assertion, with the proper timing, of the signals EN-AD, EN-DT, OE, triggers (through the signals EN-AD and EN-DT) the sequencer circuit 145, so as to generate the signals PL-A[0:31], PL-D[0:7], and also generates the suitable control signals for the memory 105 (for instance, in the case of a write access to the memory 105, the write enable signal WE). Additionally, the control unit 130 has an input for a clock signal connected to a contact pad PAD[4] destined to be connected to a respective pin PIN1[4] of the package 1601 or PIN2[2] of the package 1602. Such pins PIN1[4] and PIN2[2] are destined to be connected to the respective clock signal lines LCLK and CK of the respective buses BUS1 and BUS2. In such way, the control unit 130, and particularly the state machine, works synchronously with the electronic system in which the integrated circuit is inserted. Finally, the control unit 130 has an input for a start signal connected to a respective contact pad PAD [5] , in turn connected to a pin PIN1[5] of the package 1601 or PIN2[3] of the package 1602; the pin PIN1[5] is destined to be connected to the signal line LFRAME of the bus BUS1, while the pin PIN2[3] is destined to be connected to the signal line SEL of the bus BUS2.

The sequencer circuit 145, in charge of the generation of the clock signals PL-A[0:31], PL-D[0:7], in addition to the signals EN-AD and EN-DT received from the control unit 130, also receives the bus selection signal B1/B2, and it also has an input for a clock signal, connected to the pad PAD [4].

The control circuit 155, that controls the turning on of the memory 105, has in turn an input connected to the pad PAD [5].

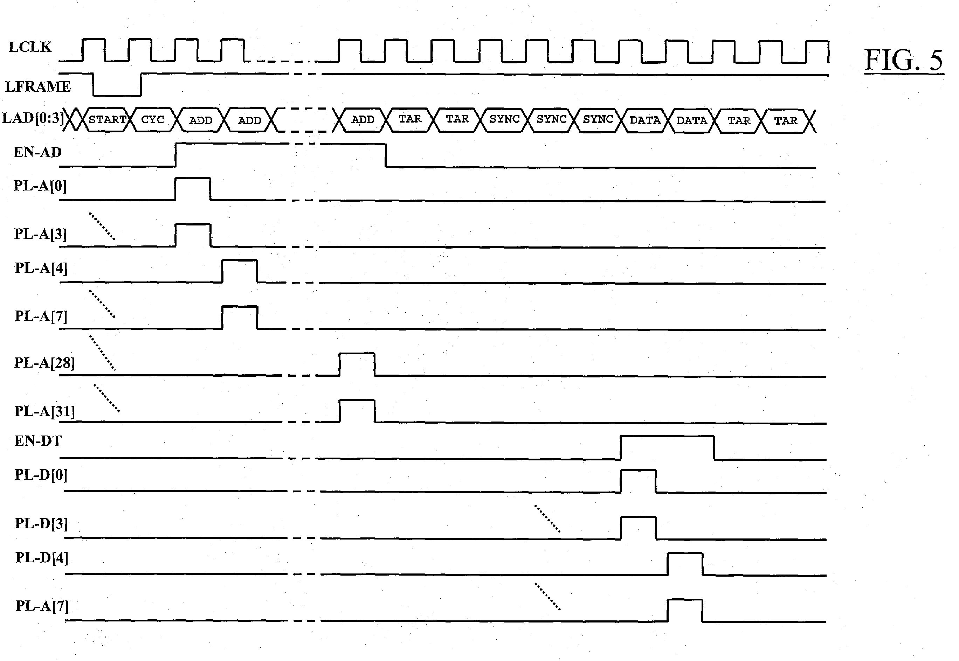

FIG. 5 shows, schematically and in simplified way, the timing of an operation of read access to the memory 105 in the case in which the integrated circuit 100 is connected to the bus BUS1, as shown in FIG. 1. Is supposed that a device external to the integrated circuit 100, for instance a microprocessor, desires to access the memory 105 so as to read the content of one location thereof. To start the read access operation, the microprocessor asserts the signal LFRAME, bringing it to the low logic level. This event is detected by the circuit 155, that accordingly asserts the memory turn-on signal CE, turning on the memory 105, and by the control unit 130, that prepares for the start of a communication transaction. Through the signal lines LAD[0:3] of the bus BUS1, in a first cycle of the clock signal LCLK the microprocessor sends to the integrated circuit 100 a (four-bit) code identifying the start *(START)* of the communication transaction. Always through the signal lines LAD[0:3] of the bus BUS1, in the second cycle of the clock signal LCLK the microprocessor sends a code *(CYC)* identifying the command to be performed. Such code is interpreted by the command interpreter of the control unit, that accordingly triggers the state machine: the signal EN-AD is asserted, to enable the loading of the latches of the address register, and the sequencer circuit 145 is triggered. In the following eight cycles of the clock signal LCLK, the sequencer circuit 145 will assert in succession, by groups of four at a time, the clock signals PL-A[0:31], so as to load into the address register the address code that is supplied to the integrated circuit 100 through the signal lines LAD[0:3], in groups of four bits at a time.

In the following two cycles (TAR) of the clock signal LCLK, the control of the bus BUS1, up to now assigned to the microprocessor, is given to the integrated circuit100. The integrated circuit 100, once taken possession of the control of the bus BUS1, sends through the signal lines LAD[0:3] a synchronism code *(SYNC), e.g.* for three consecutive cycles of the clock signal LCLK. In the meantime, the address code stored in the address register 135 is supplied in parallel to the memory 105, through the bus AD [0:22], the corresponding memory location is accessed and read, and the read datum is supplied through the bus DT[0:7] to the data register 140, wherein it is stored. Then, the control unit 130 asserts the signal EN-DT and the signal OE, thus enabling the data register 140 and the multiplexing/demultiplexing circuit 150 to put onto the signal lines LAD [0:3] the data word stored in the data register 140. This takes place in two cycles (*DATA*) of the clock signal LCLK, during which the sequencer circuit 145 initially asserts the four signals PL-D[0:3], and then asserts the four signals PL-D [4 :7]. There follow two clock cycles (*TAR*) by means of which the integrated circuit 100 returns the control of the bus BUS1 back to the microprocessor.

An access operation in writing to the memory 105 is carried out in a similar way, storing in the address register 135 the address code of the memory location to be written, received four bits at a time, and storing in the data register 140 the data word to be written, also received four bits at a time. The address code and the data word to be written, respectively stored in the address register and in the data register, will then be furnished in parallel to the memory 105, which performs a normal write operation.

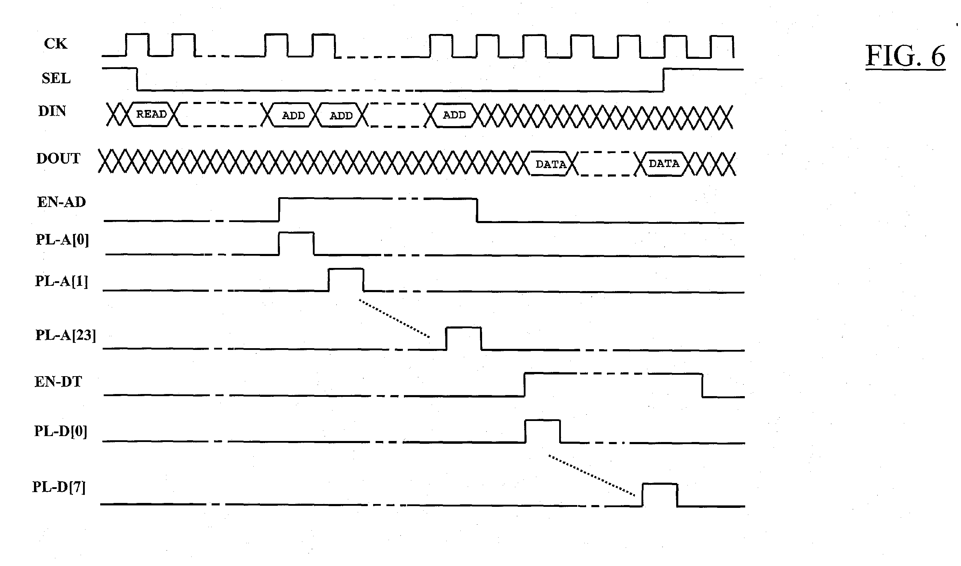

FIG. 6 shows, still in a schematic and simplified way, the timing of a similar operation of access in reading to the memory 105 in the case in which the integrated circuit 100 is connected to the bus BUS2, as shown in FIG. 2. In this case, in order to start the read access operation to the memory 105, the microprocessor asserts the signal SEL, bringing it to the low logic level. This event is detected by the circuit 155, that accordingly asserts the memory turn-on signal CE, turning on the memory 105, and by the control unit 130, that prepares to the start of a communication transaction. Through the signal line DIN, in the first eight cycles of the clock signal CK the microprocessor sends to the integrated circuit 100 a code *(READ)* identifying the command to be performed (read command). Such code is interpreted by the command interpreter of the control unit 130, that accordingly triggers the state machine: the signal EN-AD is assedrted, so as to enable the loading of the latches of the address register, and the sequencer circuit 145 is triggered. In the following twenty-four cycles of the clock signal CK, the sequencer circuit 145 will affirm, in succession and one at a time, the clock signals PL-A[0:23], so as to load into the address register 135 the address code that is supplied to the integrated circuit 100 through the signal line DIN, one bit at a time.

Through the bus AD [0: 22], the address code stored in the address register 135 is supplied in parallel to the memory 105, the corresponding memory location is accessed and read, and the read datum is fed, through the bus DT[0:7], to the data register 140, wherein it is stored. The control unit 130 then asserts the signal EN-DT and the signal OE, thus enabling the data register 140 and the multiplexing/demultiplexing circuit 150 to put onto the signal lines DOUT the data word stored in the data register 140. This takes place in eight cycles *(DATA)* of the clock signal CK, during which the sequencer circuit 145 asserts, in succession and one for every clock cycle, the signals PL-D[0:7].

A write access operation to the memory 105 is carried out in a similar way, storing into the address register 135 the address code of the memory location to be written, received one bit at a time, and storing into the data register 140 the data word to be written, also received one bit at a time. The address code and the data word to be written, respectively stored in the address register and in the data register, will then be supplied in parallel to the memory 105, through the buses AD[0:22] and DT[0:7].

Thanks to the present invention, it is possible to realize an integrated circuit that, although using a semiconductor memory having a standard design, with high addressing parallelism and high data output or data input/output parallelism, can be used both within an LPC bus architecture, and within an SPI bus architecture. In the first case, the integrated circuit will be inserted into a first type of package, comprising, among the others, four pins for the connection to the four data lines LAD[0:3] of the bus LPC. In the second case, it will be possible to use a package with fewer pins, and thus cheaper, with only two pins instead of the previous four for the connection to the lines DIN and DOUT of the bus SPI.

It can be appreciated that the possibility of interfacing the standard memory to the LPC bus or to the SPI bus is not achieved by banally integrating two separate communication interfaces, each one dedicated to a respective bus, to be used in a mutually exclusive way depending on the application, but, on the contrary, through only one communication interface, common for both the buses, and exploiting in peculiar way the structures of such interface.

The present invention has been described herein in terms of some possible embodiments thereof. It is however clear that those skilled in the art can bring several changes to the embodiments described, and even conceive other embodiments of the present invention, without for this reason departing from the scope of the invention defined in the appended claims.

For instance, although described in relation with a Flash memory, the present invention can be applied in general to any type of memory, both volatile and non-volatile.

## Claims

1. An integrated circuit comprising:
a memory (105) having an addressing parallelism and a data transfer parallelism;
a multiprotocol serial communication interface (110) configurable for interfacing the memory to a selected one among at least a first (BUS1) and a second (BUS2) external serial buses, said first and second external buses having respectively a first (LAD[0:3]) and a second (DIN,DOUT) transfer parallelism of memory address codes and data words, the second transfer parallelism being smaller than the first transfer parallelism and the first transfer parallelism being smaller than the addressing parallelism and the data transfer parallelism of the memory; and
a first (PAD [0] -PAD [3] , PIN1 [0] -PIN1 [3] ) and a second (PAD[0]-PAD[3], PIN2[0], PIN2[1]) groups of electric terminals for the connection of the integrated circuit to the first external serial bus or to the second external serial bus,
the multiprotocol serial communication interface comprising:
a register (135) for storing address codes;
a register (140) for storing read data words read from the memory;
means (150) for the selective coupling of the address codes storage register and of the read data word storage register to the first or to the second group of electrical terminals of the integrated circuit;
control means (130,145,B1/B2) to enable the loading into the address code storage register of address codes received serially through the first bus or the second bus and to supply the loaded address codes in parallel to the memory, to enable the loading into the read data word storage register of read data words received in parallel from the memory and to enable the transfer of the loaded read data words serially on the first bus or on the second bus.

2. The integrated circuit according to claim 1, further comprising a register for storing write data words to be written into the memory, selectively couplable to the first or to the second group of electrical terminals of the integrated circuit by means of said selective coupling means, and in which the control means also enable the loading into the write data word storage register of write data words to be written into the memory, received serially from the first bus or from the second bus and, and the transfer of the write data words in parallel to the to the memory.

3. The integrated circuit according to claim 2, in which said write data word storage register coincides with the read data word storage register.

4. The integrated circuit according to claim 1, 2 or 3, in which said first external bus is a bus conforming to the standard Low Pin Count, said first transfer parallelism being equal to four, and said second external bus is a bus conforming to the standard Serial Peripheral Interface, said second transfer parallelism being equal to one.

5. The integrated circuit according to claim 4, in which said control means include a generator (145) of clock signals (PL-A[0:31],PL-D[0:7]) for said storage registers, said clock signals being adapted to cause the loading/unloading of said registers from/to the first or the second external bus by groups of four bits or by single bits, depending on the bus to which the integrated circuit is connected.

6. The integrated circuit according to claim 5, in which said control means further comprises a command interpreter for interpreting commands received by the integrated circuit through said first or second external buses, and a state machine for controlling the operation of the integrated circuit depending on the command received.

7. The integrated circuit according to claim 2, in which said address code storage register is adapted to store a digital code having a number of bits at least equal to the addressing parallelism of the memory, and said read data word storage register and write data word storage register are adapted to store data words having a number of bits at least equal to the data transfer parallelism of the memory.
